# EUROPEAN PATENT APPLICATION

(11) **EP 4 417 990 A1**
(43) Date of publication of application: **21.08.2024**
(21) Application number: 23161118.7
(22) Date of filing: 10.03.2023
(51) Int. Cl.: G01R 33/34, H01Q 15/00

(54) **VOLUME COIL FOR A MAGNETIC RESONANCE IMAGING SYSTEM**

(30) Priority: 20.02.2023 US 202363447004 P
(71) Applicant: Koninklijke Philips N.V., 5656 AG Eindhoven (NL)
(72) Inventor: ZHAI, Zhiyong, Eindhoven (NL); HARVEY, Paul Royston, Eindhoven (NL)
(74) Representative: Philips Intellectual Property & Standards

(57) **Abstract**

The invention relates to a volume coil (1) for a magnetic resonance imaging system (2), comprising a front ring (3), a back ring (4) and a metasurface structure (5) with at least one metasurface (6), wherein the front ring (3) and the back ring (4) have the same shape and are arranged co-axial and parallel to each other and with a distance from each other to define a volume (7) therebetween which is provided which provides better transmit performance than conventional birdcage-type volume coils, especially at high static B₀ magnetic fields.

## Description

### FIELD OF THE INVENTION

The invention relates to the field of magnetic resonance imaging (MRI) and in particular to volume coils for magnetic resonance imaging systems.same

### BACKGROUND OF THE INVENTION

A birdcage-type quadrature radio frequency coil consists of a plurality of parallel rungs arranged axially, parallel with the static Bo magnetic field through the examination region. End-rings disposed at opposite ends of the rungs interconnect the rungs and distribute current around the rungs sinusoidally. At frequencies below 128 MHz, such a coil when driven in quadrature provides a substantially uniform transverse B1 field through the volume. Quadrature birdcage-type coils have been found to be effective volume coils such as whole-body coils, head coils, and so forth. The open cylindrical structure of a birdcage coil without a close-fitting ground shield is advantageous for head coil applications as the open geometry reduces the patient's tendency toward anxiety or claustrophobia.

Higher static Bo magnetic fields result in increased signal strength and in higher frequency nuclear magnetic resonance (NMR) since NMR is proportional to the strength of the Bo field. However, open head birdcage coils results in increased radiative losses at higher frequencies, and hence lower coil efficiency. Similar radiative loss and coil efficiency issues arise in using birdcage coils at high field for other applications. Radiative losses can be reduced somewhat by including an outer radio frequency shield of a conductive mesh or other material, but at the cost of a less open geometry and possible patient anxiety or claustrophobia. An end cap version of a birdcage coil may be used to further reduce radiation from one end of the coil, but radiative losses remain problematic at the open end of the end-capped coil.

At a static magnetic field of 7 Tesla or higher, where a close-fitting cylindrical radio frequency (RF) ground is desired, a transverse-electromagnetic (TEM) coil may be used. In a TEM coil, the rungs are replaced by rods, which are also parallel conductors arranged parallel with the static Bo magnetic field through the examination region. Unlike the birdcage geometry, however, the rods of the TEM coil are terminated at each end by electrical connection with the surrounding cylindrical radio frequency shield. A TEM coil does not have end rings to distribute current amongst the rods. The TEM coil operatively differs from the birdcage coil in its resonance modes-each rod of the TEM coil resonates with a conductive return path through the shield. The integrated radio frequency shield of the TEM coil and its consequent shielded geometry can have separate tuning and excitation of the various rods.

Generally, a volume coil can be made from two co-axial conducting ring structures which can resonate with a sinusoidal current distribution along each conducting ring. Most conventional MRI whole body transmit coils are birdcage type of volume coils. However, as explained above, at high static Bo magnetic fields of 3 T and above, the performance of birdcage transmit coil decreases with the increase of Bo field due to the shorter radio frequency wavelength.

According to WO 2008/078284 A2, a RF coil is proposed for use as an RF antenna for a MRI system, for transmitting RF excitation signals and for receiving MR relaxation signals. In that case, the RF coil includes an array of patches which are capacitively coupled with each other. The array of patches forms a resonant surface on which surface currents can be resonantly excited for generating at least one field modus.

Further, metamaterials have been applied in the technical field of magnetic resonance imaging. A metamaterial is a material engineered to have a property that is not found in naturally occurring materials. Metamaterials are typically made from assemblies of multiple elements fashioned from composite materials such as metals and plastics. The materials are usually arranged in repeating patterns, at scales that are smaller than the wavelengths of the phenomena they influence. Metamaterials derive their properties not from the properties of the base materials, but from their newly designed structures. Their precise shape, geometry, size, orientation and arrangement gives them their smart properties capable of manipulating electromagnetic waves by blocking, absorbing, enhancing or bending waves, to achieve benefits that go beyond what is possible with conventional materials. Appropriately designed metamaterials can affect waves of electromagnetic radiation or sound in a manner not observed in bulk materials. Metamaterials that exhibit a negative index of refraction for particular wavelengths have been the focus of a large amount of research. These materials are known as negative-index metamaterials.

CN 103367922 A describes a metamaterial comprising a plurality of metamaterial units arranged in an array, wherein each metamaterial unit is composed of two substrates and three artificial microstructures, and the substrates and the artificial microstructures are arranged at intervals in a laminated mode, every two neighboring artificial microstructures are connected through a metal through hole, and the artificial microstructures are circular toroids. The metamaterial has the advantage of high negative magnetic permeability. Further, a MRI magnetic signal enhancement device is described which is based on the high negative magnetic permeability metamaterial. The MRI magnetic signal enhancement device enables signals to be enhanced by making use of the characteristic that the magnetic permeability of the negative magnetic permeability metamaterial is negative, and the imaging effects of MRI imaging equipment become better.

### SUMMARY OF THE INVENTION

It is an object of the invention to provide a volume coil for a MRI system which provides better transmit performance than conventional birdcage-type volume coils, especially at high static Bo magnetic fields.

According to the invention, this object is addressed by the subject matter of the independent claims. Preferred embodiments of the invention are described in the sub claims.

Therefore, according to the invention, a volume coil for a magnetic resonance imaging system is provided, comprising a front ring, a back ring and a metasurface structure with at least one metasurface, wherein the front ring and the back ring have the same shape and are arranged co-axial and parallel to each other and with a distance from each other to define a cylindrical volume therebetween which is surrounded by the metasurface structure.

The proposed volume coil which is based on a front ring, a back ring and a metasurface structure overcomes the shortage of birdcage types of volume coils at high Bo fields. As mentioned above, metasurfaces are human-made ultrathin subwavelength structures which are able to control and specifically redistribute near electromagnetic field patterns. Here, a metasurface structure with such a metasurface is arranged between two rings which may act as resonance rungs for the volume coil. In this way, better signal-to-noise performance of the volume coil may be achieved.

Hence, with the combination of a two-ring based volume coil and metasurface materials, a new type of volume coil may be achieved which provides better transmit performance than existing birdcage-type volume coils. The proposed volume coil is especially useful at ultra-high static Bo magnetic fields. The volume coil may have better performance compared with conventional birdcage types of volume coils, especially for a whole body transmit coil at ultra-high fields. Multiple metasurfaces can be arranged in both transverse direction and along the z-axis, i.e. the longitudinal axis of the cylindrical volume, for optimal performance at desired imaging volume and Bo field. It also helps reduce the eddy currents from gradient coils and lower whole body coil heating.

In general, the metasurface may be made from different materials. Preferably, the metasurface is made from a typical printed circuit board on a dielectric support layer. Further, it is preferred that the metasurface has a thickness of sub-millimeters to a few millimeters, preferably between 0.1 mm to 3 mm, more preferably between 0.5 mm and 2 mm.

In general, the metasurface structure may comprise one single metasurface. However, according to a preferred embodiment of the invention, the metasurface structure comprises multiple metasurfaces. The use of multiple metasurfaces may be advantageous for tailoring the volume coil to specific needs.

Further, according to a preferred embodiment of the invention, the front ring and the back ring each comprise a conducting loop structure with conductive loop sections with two ends which are each coupled to another other conductive loop section by a respective capacitor at each end. In this way, both rings are designed as a chain of conductive loop sections which are coupled to each other by respective capacitors. In this respect, according to a preferred embodiment of the invention, the front ring and the back ring are tuned to the same resonance frequency with sinusoidal current distribution by the capacitors. This generates a uniform B₁-field in the space between the front ring and back ring, which is similar to the uniform B₁-field of a birdcage type of volume coil.

In this respect, according to a further preferred embodiment of the invention, a second pair of a front ring and a back ring, which preferably resemble to the first pair of front ring and the back ring or have an identical design as the front ring and the back ring, are placed either between the first pair of the front ring and the back ring or outside of the first pair of the front ring and the back ring. Preferably, the first pair of the front ring and the back ring are tuned to the same first resonance frequency with sinusoidal current distribution by the first set of capacitors for proton magnetic resonance imaging. Preferably, the second pair of front ring and back ring are tuned to the same second resonance frequency with sinusoidal current distribution by a second set of capacitors which resemble to a capacitor for a second nuclear magnetic resonance imaging which is different by at least one parameter from the nuclear magnetic resonance imaging with the first pair of the front ring and the back ring.

Further, according to a preferred embodiment of the invention, there are more than two pairs of a front ring and a back ring which resemble to the first pair of the front ring and the back ring. Preferably, each pair of a front ring and a back ring are tuned to a different resonance frequency for multiple nuclear magnetic resonance imaging.

In general, the metasurface may be designed in different ways. However, according to preferred embodiment of the invention, the metasurface structure comprises at least one metasurface which is an arrangement of an outer conducting loop and multiple inside strips, wherein the inside strips are arranged in the area which is surrounded by the outer conducting loop, the inside strips are not in contact with the outer conducting loop, each inside strip is coupled to at least one other inside strip and the outer conducting loop comprises multiple loop sections wherein each loop section is coupled to another loop section. While, in general, the number of the loop sections may vary, according to a preferred embodiment of the invention, four loop sections are provided.

Further, according to preferred embodiment of the invention, the inside strips which are coupled to each other run parallel to each other. Furthermore, according to a preferred embodiment of the invention, loop sections which are coupled to each other are arranged perpendicularly to each other. It is also preferred that the inside strips and the loop sections run in the same plane. This plane may be flat or curved.

Further, such a design is preferred wherein each inside strip is coupled to at least one other inside strip via a capacitor or is short-circuited to the other inside strip. Similarly, according to a preferred embodiment of the invention, each loop section is coupled to another loop section via a capacitor or is short-circuited to the other loop section. The capacitors are preferably either discrete lumped capacitors or distributed capacitors.

Preferably, to tune the volume coil to a desired resonance frequency for MRI, the capacitors in each metasurface and the capacitor in both the front ring and the back ring are adjusted iteratively for optimized performance in a region of interest of an MRI apparatus.

In general, the metasurface structure may be self-supporting. However, according to a preferred embodiment of the invention, the metasurface structure comprises a dielectric support on which the loop sections and the inside strips are arranged. This provides for a versatile and solid design.

According to a preferred embodiment of the invention, the volume is at least partially surrounded by a radio frequency shield. In this respect, according to a preferred embodiment of the invention of, the radio frequency shield is separate from the front ring and the back ring which means that the radio frequency shield is provided as a separate device. In this respect, the radio frequency shield is preferably arranged on or over the skin surface of the cylindrical volume. Further, the radio frequency shield may be arranged between the front ring and the back ring or may surround the front ring and the back ring.

According to another preferred embodiment of the invention, the radio frequency shield is at least partly formed by the front ring and the back ring. Especially, it is preferred that the radio frequency shield is completely formed by the front ring and the back ring which are only separated by a small slit. This provides for any easy and light design of the complete volume coil arrangement.

The invention also concerns a magnetic resonance imaging system with a volume coil as described above.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a volume coil according to an embodiment of the invention,
Fig. 2 schematically depicts a metasurface structure for a volume coil according to an embodiment of the invention,
Fig. 3 schematically depicts a part of a volume coil with three metasurfaces according to an embodiment of the invention in an unwound state,
Fig. 4 schematically depicts a volume coil with a radio frequency shield according to an embodiment of the invention in a perspective view,
Fig. 5 schematically depicts a volume coil with a radio frequency shield according to another embodiment of the invention in a perspective view,
Fig. 6 schematically depicts a volume coil with a radio frequency shield according to still another embodiment of the invention in a perspective view,
Fig. 7 schematically depicts a volume coil without the radio frequency shield according to an embodiment of the invention in a perspective view and
Fig. 8 schematically depicts a volume coil according to an embodiment of the invention for a magnetic resonance imaging system.

### DETAILED DESCRIPTION OF EMBODIMENTS

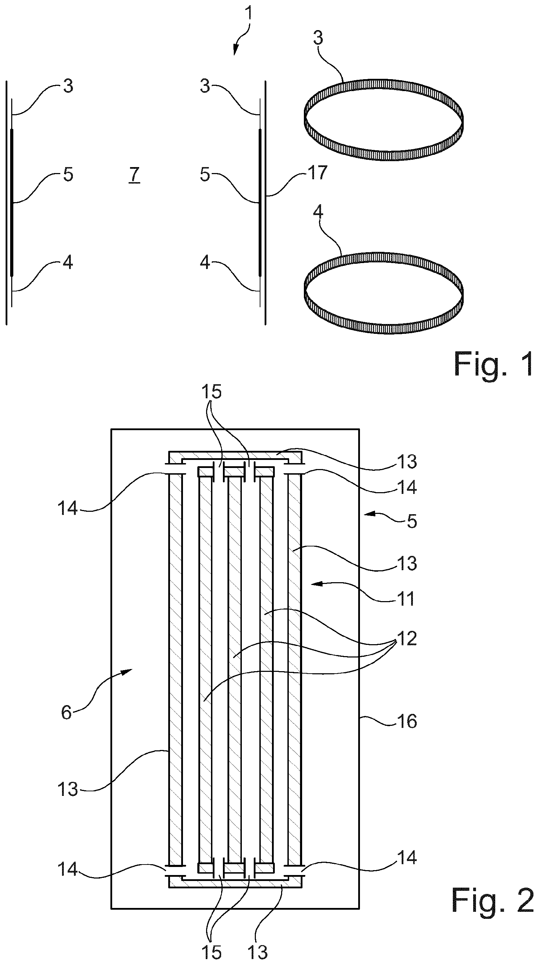

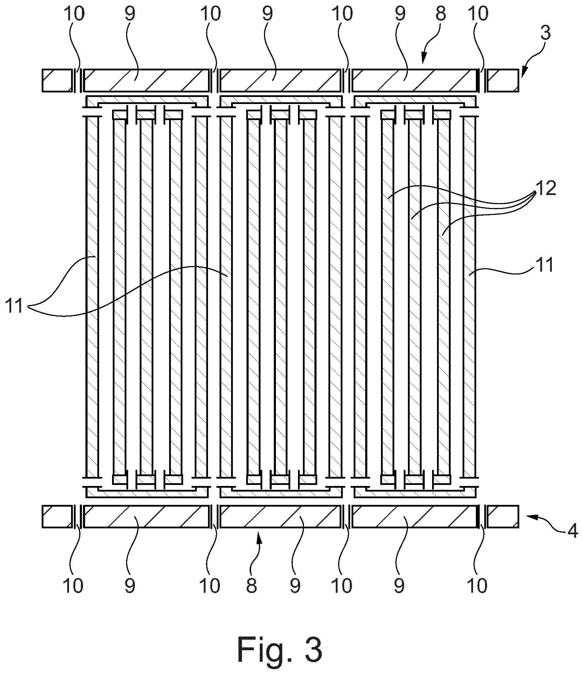

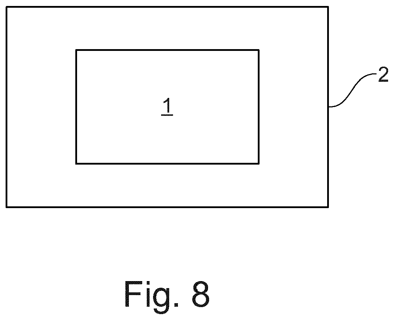

Fig. 1 schematically depicts a volume coil 1 according to an embodiment of the invention for a magnetic resonance imaging system 2 which is schematically depicted in Fig. 8. On the left side, Fig. 1 shows a longitudinal sectional view of the volume coil 1 and a radio frequency shield 17 surrounding the volume coil 1. On the right side, Fig. 1 shows perspective views of a front ring 3 and a back ring 4. Therefore, the volume coil 1 comprises a front ring 3, a back ring 4 and a metasurface structure 5 with multiple metasurfaces 6, which are shown in more detail in Figs. 2 and 3. As depicted in Fig. 1, the front ring 3 and the back ring 4 have the same circular shape and are arranged co-axial and parallel to each other and with a distance from each other to define a cylindrical volume 7 therebetween. This cylindrical volume 7 is surrounded by the metasurface structure 5. The metasurface structure 5 and the rings 3, 4 are surrounded by the radio frequency shield 17.

As only implied by Fig. 1 but shown in more detail in Fig. 3, the front ring 3 and the back ring 4 each comprise a conducting loop structure 8 with conductive loop sections 9 with two ends which are each coupled to another conductive loop section 9 by a respective capacitor 10 at each end. In this respect, it should be noted that or the sake of clarity, not all reference signs are shown in all Figures.

According to the embodiment of the invention described here, the front ring 3 and the back ring 4 are tuned to the same resonance frequency with sinusoidal current distribution by the capacitors 10. Further, while Fig. 3 only shows three metasurfaces 6, the metasurface structure 5 of the volume coil 1 described here comprises 16 metasurfaces 6 in total.

The metasurface structure 5 according to this embodiment of the invention comprises such metasurfaces 6 which are each an arrangement of an outer conducting loop 11 and multiple inside strips 12, wherein the inside strips 12 are arranged in the area which is surrounded by the outer conducting loop 11, the inside strips 12 are not in contact with the outer conducting loop 11, each inside strip 12 is coupled to at least one other inside strip 12 and the outer conducting loop 11 comprises multiple loop sections 13 wherein each loop section 13 is coupled to two other loop sections 13 via a respective capacitor 14. In detail, three inside strips 12, i.e. one inside strip 12 and two outside strips 12, are provided which run straight and are parallel to each other. At their ends, the inside strips 12 are coupled to at least one other inside strip by a respective capacitor 15. This means, that the inner inside strip 12 is coupled to both outside strips 12 while the outside strips 12 are not directly coupled to each other. Further, the inside strips 12 and the loop sections 13 are arranged on a dielectric support 16 made of a plastic material and run in the same plane which is a curved plane defined by the skin surface of the cylindrical volume 7. The capacitors 14 and 15 can be either discrete lumped capacitors or distributed capacitors.

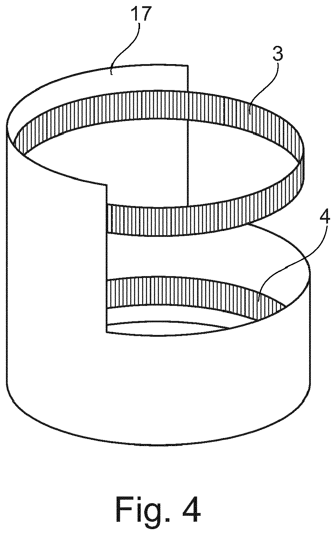

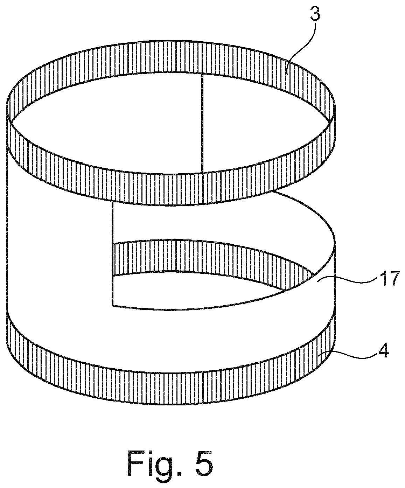

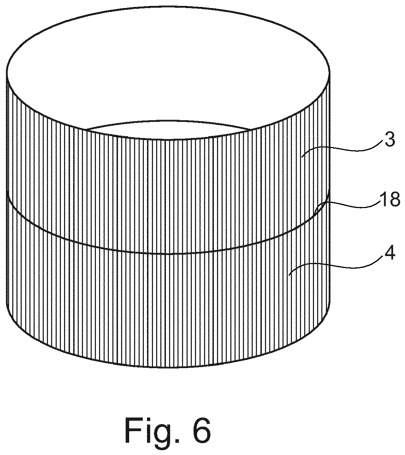

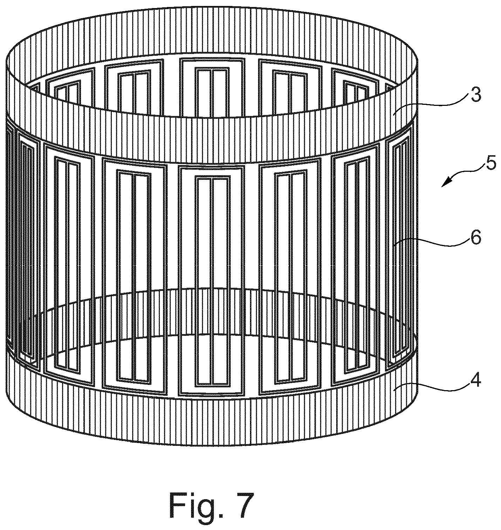

As depicted in Figs. 4, 5 and 6, the cylindrical volume 7 is at least partially surrounded by the radio frequency shield 17. In this respect, different designs may be used: It is an option that the radio frequency shield 17 is separate from the front ring 3 and the back ring 4. Such designs are shown in Figs. 4 and 5. According to the embodiment shown in Fig. 4, the radio frequency shield is arranged over the skin surface of the cylindrical volume 7 and surrounds the front ring 3 and the back ring 4. Alternatively, as depicted in Fig. 5, the radio frequency shield 17 is arranged on the skin surface of the cylindrical volume 7 and between the front ring 3 and the back ring 4. In both cases, i.e. for the designs of the Figs. 4 and 5, the design of the volume coil 1 may be as depicted in Fig. 7 which shows a volume coil 1 without a radio frequency shield.

However, as depicted in Fig. 7, it is also possible that the radio frequency shield 17 is at least partly formed by the front ring 3 and the back ring 4. Here, the radio frequency shield 17 is completely formed by the front ring 3 and the back ring 4 which are only separated by a small slit 18. In this case, each ring 3, 4 is further slit along the z-axis for placing tune capacitors 10 (not shown). In this way, during transmit phase, no radio frequency shield exists which may result in higher radio frequency transmit efficiency. During the local coil receive phase, switches such as pin diodes can be placed both along the middle slit 18 and across capacitors 10 and switched on to electrically connect all pieces of the two rings 3, 4 together to form a whole radio frequency shield.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| volume coil | 1 |
| magnetic resonance imaging system | 2 |
| front ring | 3 |
| back ring | 4 |
| metasurface structure | 5 |
| metasurface | 6 |
| volume | 7 |
| conducting loop structure | 8 |
| conductive loop sections | 9 |
| capacitor of the conducting loop structure | 10 |
| outer conducting loop | 11 |
| inside strips | 12 |
| loop sections | 13 |
| capacitor outer conducting loop | 14 |
| capacitor of the inside strips | 15 |
| dielectric support | 16 |
| radio frequency shield | 17 |
| slit | 18 |

## Claims

1. Volume coil (1) for a magnetic resonance imaging system (2), comprising a front ring (3), a back ring (4) and a metasurface structure (5) with at least one metasurface (6), wherein
the front ring (3) and the back ring (4) have the same shape and are arranged co-axial and parallel to each other and with a distance from each other to define a cylindrical volume (7) therebetween which is surrounded by the metasurface structure (5).

2. Volume coil (1) according to claim 1, wherein the metasurface (6) has a thickness between 0.1 mm and 3 mm.

3. Volume coil (1) according to claim 1 or 2, wherein the metasurface structure (5) comprises multiple metasurfaces (6).

4. Volume coil (1) according to any one of the preceding claims, wherein the front ring (3) and the back ring (4) each comprise a conducting loop structure (8) with conductive loop sections (9) with two ends which are each coupled to two other conductive loop sections (9) by a respective capacitor (10) at each end.

5. Volume coil (1) according to claim 4, wherein the front ring (3) and the back ring (4) are tuned to the same resonance frequency with sinusoidal current distribution by the capacitors (10).

6. Volume coil (1) according to any one of the preceding claims, wherein the metasurface structure (5) comprises at least one metasurface (6) which is an arrangement of an outer conducting loop (11) and multiple inside strips (12), wherein the inside strips (12) are arranged in the area which is surrounded by the outer conducting loop (11), the inside strips (12) are not in contact with the outer conducting loop (11), each inside strip (12) is coupled to at least one other inside strip (12) and the outer conducting loop (11) comprises multiple loop sections (13) wherein each loop section (13) is coupled to two other loop sections (13).

7. Volume coil (1) according to claim 6, wherein inside strips (12) which are coupled to each other are parallel to each other.

8. Volume coil (1) according to claim 6 or 7, wherein loop sections (13) which are coupled to each other are perpendicular to each other.

9. Volume coil (1) according to any one of claims 6 to 8,wherein the inside strips (12) and the loop sections (13) run in the same plane.

10. Volume coil (1) according to any one of claims 6 to 9,wherein each inside strip (12) is coupled to at least one other inside strip (12) via a capacitor (15) or is short-circuited to the other inside strip (12).

11. Volume coil (1) according to any one of claims 6 to 10,wherein each loop section (13) is coupled to another loop section (13) via a capacitor (14) or is short-circuited to the other loop section (13).

12. Volume coil (1) according to any one of claims 6 to 11, wherein the metasurface structure (5) comprises a dielectric support (16) on which the loop sections (13) and the inside strips (12) are arranged.

13. Volume coil (1) according to any one of the preceding claims, wherein the volume (7) is at least partially surrounded by a radio frequency shield (17).

14. Volume coil (1) according to claim 13, wherein the radio frequency shield (17) is at least partly formed by the front ring (3) and the back ring (4).

15. Magnetic resonance imaging system (2) with a volume coil (1) according to any one of claims 1 to 14.
